# EUROPEAN PATENT SPECIFICATION

(11) **EP 3 172 397 B1**
(45) Date of publication and mention of the grant of the patent: **02.12.2026**
(21) Application number: 15739635.9
(22) Date of filing: 23.07.2015
(51) Int. Cl.: E21B 41/00, E21B 33/035

(54) **POWER SWITCHING ARRANGEMENT FOR LINE INSULATION MONITORING**
STROMSCHALTUNGSANORDNUNG ZUR LEITUNGSISOLATIONSÜBERWACHUNG
AGENCEMENT DE COMMUTATION DE PUISSANCE PERMETTANT UNE SURVEILLANCE D'ISOLATION DE LIGNE

(30) Priority: 24.07.2014 GB 201413152
(43) Date of publication of application: 31.05.2017
(73) Proprietor: Baker Hughes Energy Technology UK Limited, Bristol BS48 1BS (GB)
(72) Inventor: DAVIS, Julian Richard, Bristol BS48 1BS (GB); PUCHIANU, Silviu, Bristol BS48 1BS (GB); MORLEY, Graham Thomas, Bristol BS48 1BS (GB); SIMPSON, Steven Lewis Charles, Bristol BS48 1BS (GB)
(74) Representative: Novagraaf Group
(86) International application number: PCT/EP2015/066914
(87) International publication number: WO 2016/012554

(56) References cited:
- EP-A1- 1 316 672
- EP-A2- 1 355 037
- EP-A2- 2 339 359
- WO-A1-03/005049
- US-A- 3 950 742
- US-A- 4 015 200
- US-A- 5 514 964
- US-A1- 2004 149 446
- US-A1- 2010 220 431
- US-A1- 2013 218 359

## Description

This invention relates to a method of performing line insulation monitoring of a pair of conductor lines at least partially located in a cable, a power switching arrangement and a hydrocarbon extraction facility.

WO 03/005049 A1 discloses connecting a multiple insulation tester to a target cable. EP 1 316 672 A1 discloses a power supply means for an underwater hydrocarbon production system.

The present invention relates to an AC power switching system which is primarily intended for deployment within an underwater (e.g. subsea) AC power distribution network (at a power switching node or similar equipment) for an underwater hydrocarbon extraction facility, to switch AC power (under topside control) to down-stream equipments such as a subsea control module (SCM), or similar equipment, comprising a subsea electronics module (SEM) or similar equipment. It should be noted that the terms SEM and SCM are well-known and standard terms in the subsea hydrocarbon extraction industry.

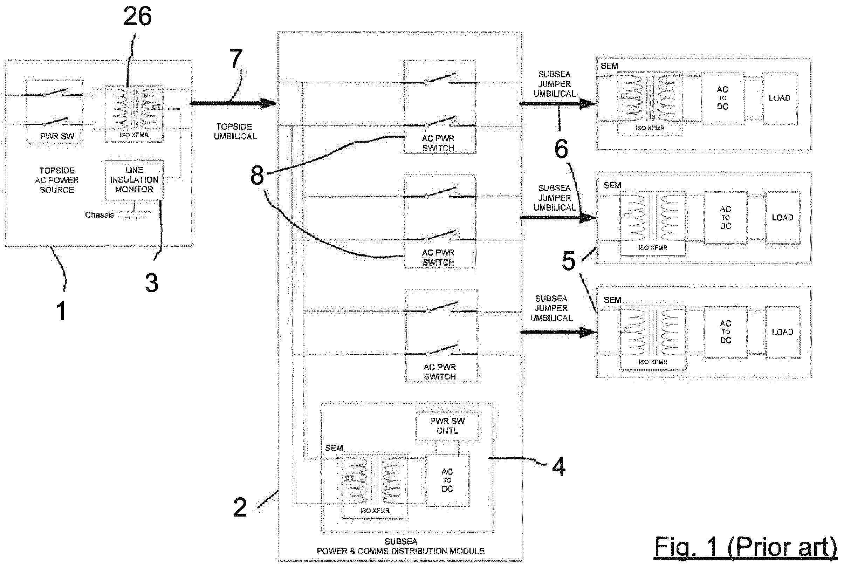

Fig. 1 schematically shows a general power distribution network topology for an underwater hydrocarbon extraction facility, in this case a subsea oil / gas facility. The system comprises topside components 1 which would typically be located on the surface, for example on land or on a platform, and subsea components 2 located at the sea floor. The topside components include, as shown, an AC power source and line insulation monitor (LIM) 3. The subsea components comprise, in this case, a power and communications subsea distribution module including a SEM 4 and distribution means for supplying AC power to a number of separate SEMs 5 via subsea jumper umbilicals 6. AC power switches 8 are provided in each branch of L1 and L2, these are operable in pairs, so that in a closed configuration, current may flow through both L1 and L2, or in an open configuration, where current flow through each of L1 and L2 is prevented. The topside components 1 and subsea components 2 are linked by a topside "umbilical" cable 7, which typically carries many different lines between the surface and subsea, including various electrical and hydraulic lines as is well-known in the art. Of particular interest for the purposes of the present invention is an electrical power conductor pair carried by the umbilical, comprising conductors L1 and L2.

In more details, the key elements of the power distribution network shown in Fig. 1 are as follows:

### Topside Equipment

The topside equipment 1 comprises (as a minimum) the following system components that interface directly or indirectly with the topside to subsea umbilical:-

### i) Topside AC power switch or Circuit Breaker (CB)

This is an AC power switch used to switch power to the subsea power network. The switch / circuit breaker can be used to power off the power distribution network in response to a user command, or if a fault condition is detected.

The power switch / CB operation is not necessarily solid-state or AC power phase controlled or synchronised, and as such the AC power waveform (as delivered to the subsea equipment) can be interrupted at any point in the AC power cycle.

### ii) Step-Up Transformer 26

This transformer 26 acts to boost 'mains' voltages (115V or 230V/240V) to levels more compatible with subsea AC power transmission (300V to 600V AC).

The transformer also provides galvanic isolation between the topside AC power source (and associated equipment) and the subsea power distribution network.

### iii) Line Insulation Monitor (LIM)

The LIM equipment is used to detect breakdown of the insulation between the power conductor pair L1, L2 and earth. This detection is performed by the LIM measuring the leakage current to chassis earth when a DC bias is applied to the umbilical conductors L1 and L2 with respect to chassis earth, as is generally known in the art.

### Up-stream Topside Umbilical 7

This is a composite construction subsea umbilical cable, typically combining both hydraulic and electrical services, including power conductor pairs for distribution of topside AC power to the subsea control system.

### Subsea Power Distribution Hub

This is a subsea power hub that switches AC power delivered from the topside umbilical jumper to one or more down-stream power distribution networks. AC power switching is performed under the control of the topside equipment and is supplemented with protection features to interrupt power delivery if a fault condition (overload condition) is detected.

### Down-Stream Subsea In-field Umbilical or Subsea Jumper 6

Each jumper 6 may comprise either a composite construction subsea umbilical (typically combining both hydraulic and electrical services including power conductor pairs) or a simple electrical jumper for distribution of switched hub AC power to the subsea control system.

### Down-Stream Load

The subsea down-stream load (e.g. an SEM 5 or SCM or similar equipment) comprises, as a minimum, the following system components that interface directly or indirectly with the switching hub umbilical (or jumper):-

### i) Step-Down Transformer:

A transformer to 'step-down' the AC power transmission voltage to a level more compatible with AC to DC power conversion. The transformer also provides galvanic isolation between the umbilical/jumper AC power jumper (AC power source) and the subsea power distribution network from the subsea electrical equipment (e.g. an SEM or SCM) internal electronics. L1 and L2 are connected to a winding of this transformer.

### ii) AC to DC Power Converter:

This is usually a power-factor corrected converter which presents a constant power demand to the power distribution network as the input supply voltage varies. The converter displays true negative impedance characteristics: as input voltage increases, the input current decreases and vice versa.

It has been found that it would be advantageous to be able to provide downstream umbilical isolation, and to enable LIM surveying prior to supplying AC power, something not possible with known systems as described above.

It is an aim of the present invention to achieve these beneficial features.

This aim is achieved through the use of independently operable power switches in each of L1 and L2, and employing a controlled switching sequence prior to powering on.

In accordance with a first aspect of the present invention there is provided a method according to claim 1.

In accordance with a second aspect of the present invention there is provided a line insulation monitoring arrangement according to claim 7.

In accordance with a third aspect of the present invention there is provided a hydrocarbon extraction facility comprising a surface location and an underwater location according to claim 8.

Other aspects of the present invention are set out in the accompanying claims.

The invention will now be described with reference to the accompanying drawings, in which:
Fig. 1 schematically shows a known general power distribution network topology for an underwater hydrocarbon extraction facility;
Fig. 2 schematically shows the topology of an AC power switch architecture in accordance with an embodiment of the present invention;
Fig. 3 schematically shows a LIM surveying process in accordance with an embodiment of the present invention;
Fig. 4 schematically shows a LIM surveying process in accordance with an alternative embodiment of the present invention; and
Fig. 5 schematically shows a LIM surveying process in accordance with a further embodiment of the present invention.

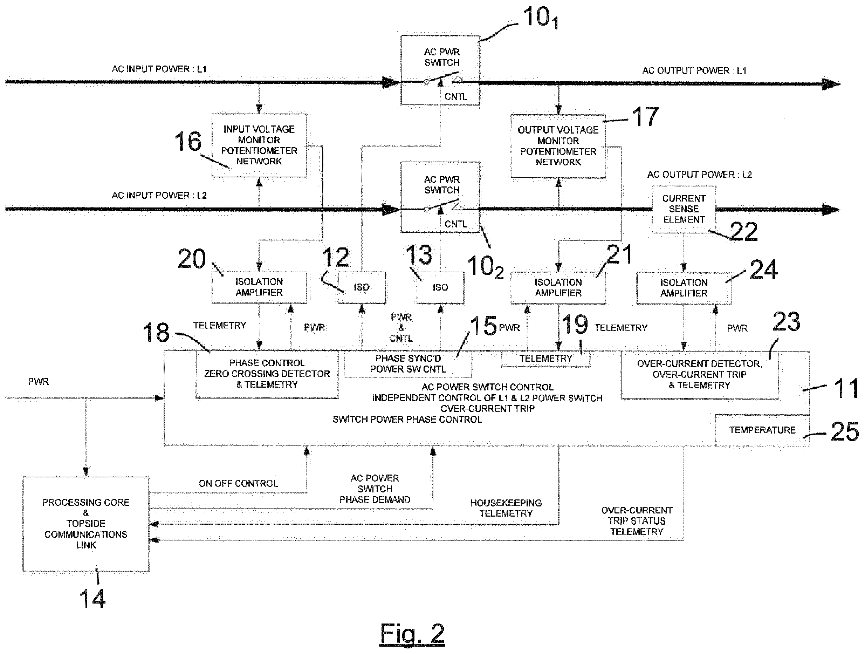

An embodiment of the present invention, employed within a subsea AC power distribution network topology generally similar to that of Fig. 1, will now be described, with the AC power switch architecture being outlined in Fig. 2.

As in the known system of Fig. 1, power switches 101, 102 are respectively provided in each of conductors L1 and L2. Each power switch 101, 102 comprises a solid state relay (SSR) element or equivalent. Activation of each switch is controlled by an AC power switch control 11, which, via an integrated phase synchronised power switch control element 15, provides independent control of the L1 and L2 switches 101 and 102, providing control signals to the switches via respective isolators 12 and 13.

The power switch control 11 receives on / off controls, including power switch phase demands, from a processing core and topside communications link 14, which is capable of receiving operating instructions from the surface.

Both the switch control 11 and processing core 14 receive operational power from the surface.

In alternative embodiments, switch operation is controlled by subsea control means, such as an SCM or SEM. Power could also be received by local subsea power storage or generation means.

It should firstly be noted that within this architecture, each AC power switch's SSR elements (or equivalent) could be based on either thyristor, i.e. silicon controlled rectifier (SCR), or insulated gate bipolar transistor (IGBT) technology depending upon the application and the function performed by the SSR. These two alternatives are briefly discussed below:

### i) SCR-based SSR

A power switch design based on 'back to back' thyristors (SCR) configured as an SSR, where switch ON (conduction) is initiated by triggering the SCR device gate drive and switch OFF occurs via SCR natural commutation (i.e. where the load current falls below the SCR holding current) after the SCR gate drive has been removed/disabled. The SCR gate control can be implemented using pulse control via an isolation transformer, however if the SSR design is to provide clean transitions between positive and negative half-power conduction cycles then use of continuously energised SCR gate drives is preferable to provide good performance.

### ii) IGBT-based SSR

An SSR design based on 'back-to-back' IGBT devices configured as an SSR, where switch ON (conduction) is initiated by biasing the IGBT device gate drive, and the IGBT must remain biased for the IGBT conduction to be maintained. IGBT switch OFF occurs when the IGBT gate bias is removed or reversed. No natural conduction commutation occurs in the IGBT, so inductive loads can present power-off transient problems if the IGBT is not suitably protected and controlled. The IGBT gate control requires a continuous drive to provide continuous conduction and clean transitions between positive and negative half power conduction cycles.

The choice of SSR will also depend on the following factors:
- IGBT leakage current performance is superior to SCR leakage current performance when switched off;
- The IGBT does not naturally commutate off when gate drive is removed, so power off transients (due to inductive loads) can present significant design issues;
- The IGBT control characteristics enable a more responsive over-current protection feature to be implemented, as the IGBT switches off as soon as the gate drive is removed, so fault currents need not be supported until the power phase current naturally commutates to zero current; and
- Back-to-back IGBTs have been employed and are very effective at switching 600V AC (to simulate relay and circuit breaker contact bounce) and produce negligible leakage when off.

A further alternative is to use a combination approach, i.e. a power switch implemented using an IGBT and SCR SSR combination, to achieve the optimum power switch design characteristics. As an example, (assuming a series connected switch pair configuration) the L1 power switch 101 element could be implemented using a SCR SSR and the L2 power switch 102 element could be implemented using an IGBT SSR. The SCR SSR could be used for the 'ultimate' delivery of power to the load (last switch to be closed and first switch to be opened), and with the IGBT SSR used for the 'making safe' and isolation of the load (first switch to be closed and last switch to be opened). The SCR SSR could be employed for phase-controlled power delivery and the IGBT SSR employed to provide high integrity load isolation. A combination of SSR technologies may provide improved performance compared with that offered by a single technology. Furthermore, common cause failure mechanisms may be reduced if different SSR technologies are employed.

Returning to Fig. 2, various other features are shown, which, while generally present in a working switch topology, are not of direct consequence to the present invention. These include:
- input and output voltage monitoring potentiometer networks 16, 17, operatively connected to, respectively, a phase control zero crossing detector & telemetry element 18 and telemetry element 19 both integrated into the control 11, via isolation amplifiers 20, 21;
   a current sensing element 22 located on L2, which provides monitoring signals to an over-current detector, over current trip & telemetry element 23 integrated within control 11, via an isolation amplifier 24;
   a temperature sensing element 25 integrated within control 11.

Using these features, the control 11 can provide housekeeping telemetry and over-current trip status telemetry to the processing core 14.

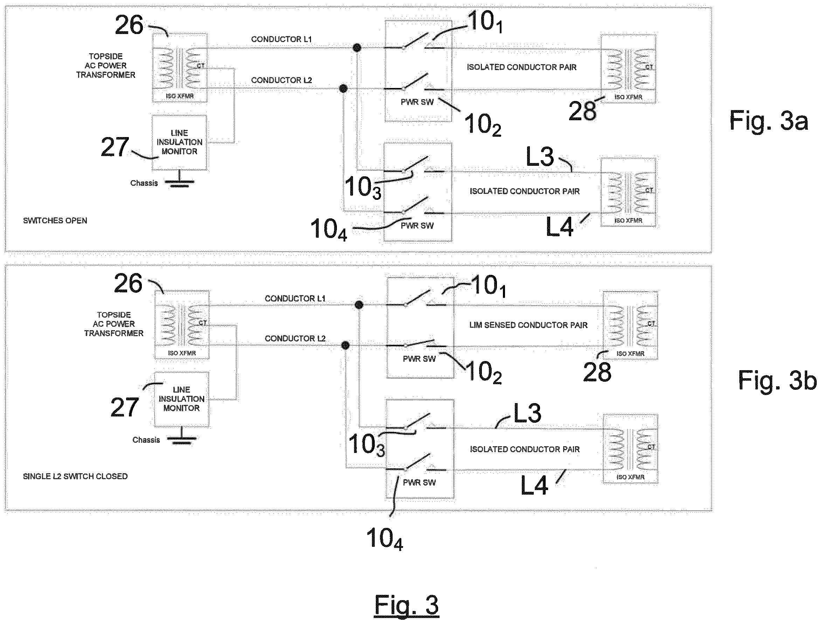

A method of providing downstream umbilical isolation and LIM surveying prior to power on will now be described, with reference to Fig. 3, where as far as possible the numbering system used for Fig. 1 has been retained for like components. This schematically shows a simplified topology in two different switching states. In the top figure, Fig. 3a, both switches 101 and 102 are open, blocking current therethrough, while in the lower figure, Fig. 3b, showing the switches in a monitoring configuration, one switch 102 has been closed independently of switch 101, allowing current in L2 to flow through. In both Figs. 3a and 3b, for clarity the only topside components shown are the topside AC power transformer 26 and LIM 27. Subsea, at the distribution module, the conductor pair branches into one additional isolated conductor pair, L3, L4, including respective switches 103, 104. Pairs L1, L2 and L3, L4 pass via respective subsea jumper umbilicals to respective SEMs, of which only an input transformer 28 is shown.

As previously described, switches 101, 102 are provided in the L1 and L2 power lines to facilitate isolation of the downstream power conductors. Initially, all switches are kept open, as shown in Fig. 3a. To perform a LIM survey of the downstream umbilical, i.e. the subsea jumper umbilical (power pair), only one of the two in-line power switch elements is switched on prior to full 'power on'. In Fig. 3b, this is switch 102, but switch 101 could equally be used. With one of the series switch elements 101, 102 closed, the topside LIM 27 can "see through" the subsea power switch to facilitate line insulation monitoring of the downstream umbilical prior to application of AC power. In other words, closing of one switch creates an unbroken conductor line between the topside, down the topside umbilical (L2), through the closed switch 102, through the downside umbilical (L2), through a winding of subsea transformer 28 and back up the other conductor (L1) as far as open switch 101. It should be noted that only one switch need be closed in this way, it is unnecessary to then open switch 102 and close switch 101 (or vice versa). With one switch closed, LIM surveying can be performed.

Following testing of L1 and L2, conductor pair L3, L4 may then be surveyed in a generally similar manner, with switches 103, 104 being independently operable as for 101 and 102.

For this step, all four switches 101, 102, 103 and 104 are held open to prevent current flow therethrough, and then one of switches 103 or 104 is independently closed to enable a LIM survey of conductor pair L3, L4 to be performed.

It should be noted that additional power branches may also be provided, in which case each power branch could be individually LIM surveyed in this manner.

Once the or each power branch has been LIM surveyed in this way, the system may be powered on.

Those skilled in the art may recognise that SCR switch element leakage may make this feature/methodology redundant or impractical if the topside LIM can "see through" the SCR AC power switching elements be they configured ON or OFF. However the dual switch power control methodology described above will be required if dual series connected in-line IGBT based SSRs are employed. Any SCR-based SSR will exhibit a degree of leakage which will facilitate "through-sensing" to some extent. However, if both of the switches include IGBT & SCR elements then line isolation can be assured.

An IGBT (or similar)-based power switch could be considered as an alternative to the SCR-based power switching module design described above or perhaps a supplementary element (extra in-line switching element) just to provide the required isolation. The IGBT SSR in-line switching element would prevent SCR SSR power switch leakage but would require more attention to the switch gate drive (if used as the primary power switching element rather than an SCR based design) particularly when the device was switched off (as the IGBT would switch off as soon as the gate drive was removed as compared with the SCR which will naturally commutate off, as the thyristor current reduces to near zero value, after the thyristor gate drive is removed).

Alternatively, IGBT and SCR-based combination series connected SSRs could be employed, assuming that is that the voltage drop and power dissipation in each of the series connected switching elements could be tolerated. SCR-based SSRs could be used for power control requiring natural commutation and IGBT-based SSRs for line isolation.

In accordance with the present invention therefore, the integrity of the downstream umbilical power conductor insulation (both L1 and L2 conductors with respect to chassis earth) can be appraised using the topside LIM function prior to powering on the downstream umbilical (the powering on being achieved by closing both of the L1 and L2 power switches). This appraisal is achieved by closing either one of the AC power switch elements (i.e. connecting one of L1 or L2 but not both together). By closing a single AC power switch element, the downstream umbilical is not subjected to the application of an AC voltage (applied differentially between L1 and L2), but does enable the topside LIM DC bias voltage to be applied to both the L1 and L2 downstream power conductors (as the topside LIM DC bias 'sees through' both the closed AC power switch and the downstream load input transformer).

Thus by providing independent control of the L1 and L2 power switches it is possible to assess the integrity of the insulation, using the topside LIM 27, of both the downstream umbilical and the load input power stage, before applying power differentially to the L1 and L2 conductors.

Furthermore, should an insulation breakdown condition develop to the extent that the topside LIM 27 is tripped, the independent control of the L1 and L2 power switches enables the user, under topside command, to investigate and isolate any umbilical elements downstream of the AC power switches (if that is where the insulation breakdown fault has developed, as opposed to an insulation breakdown of the main umbilical).

### Alternative embodiment for DC configurations

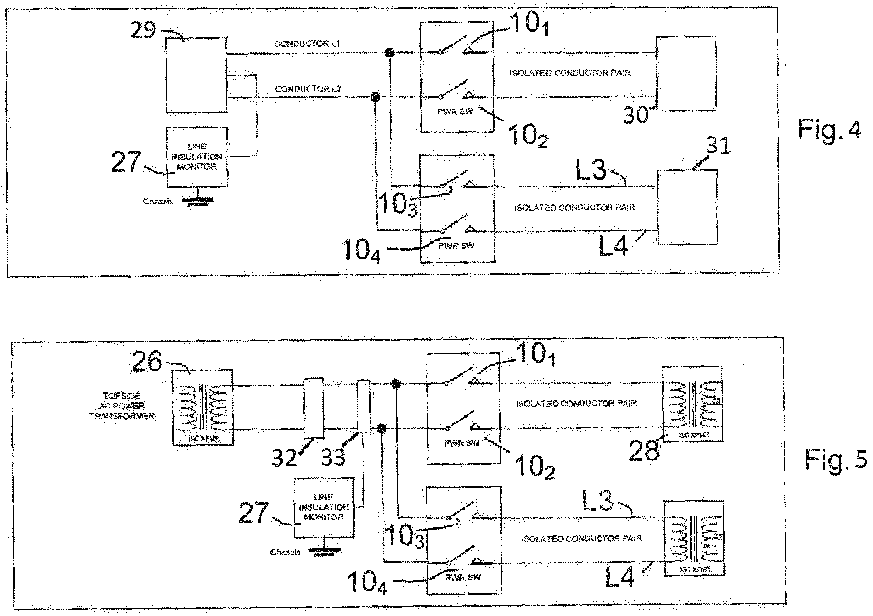

While the above-described embodiment is suitable for AC power distribution networks, it will be appreciated by those skilled in the art that the present invention could equally be used to provide LIM surveying in DC networks. The apparatus used would be substantially similar to that previously described, with the main difference that no transformer (e.g. 26 in Fig. 3) would be provided. There would also be no transformer provided in the power delivery train subsea for a DC system. An example of this type of system is shown in Fig. 4, where components from Fig. 3a retain their reference numerals as appropriate. As the system receives DC power, the topside transformer is replaced with a simple electrical connector 29. The subsea transformers have been removed, and the isolated conductor pairs connect directly to the subsea loads 30, 31.

Depending on the nature of the DC input power conversion stage(s), it might be necessary to perform two LIM surveys, in case the DC input does not conduct sufficient DC for the LIM loop back measurement technique to work. In this case, after the initial L1 and L2 OFF (open) step, one of these switches could be independently closed and a LIM survey performed, followed by a reversal of the switching states for the two switches, and a LIM survey performed again, e.g.: L1 ON L2 OFF followed by L1 OFF L2 ON.

### Alternative embodiment for subsea LIM

With some network arrangements, it is not possible to use, at least exclusively, a topside LIM for insulation monitoring of the power network. For example, the network may include an isolation transformer, located subsea. In that case, a topside LIM would not be able to "see past" the isolation transformer to monitor the insulation down-stream of that transformer. In such cases, it is possible to use a subsea-based LIM to effect monitoring, with the output from the subsea LIM being passed upstream for processing in a conventional manner. The methodology of the present invention is equally applicable when using such subsea-LIMs, whether AC or DC is used. An example of this type of system is shown in Fig. 5, where components from Fig. 3a retain their reference numerals as appropriate. An isolation transformer 32 is located in the network at the subsea end of the umbilical power conductor pair. To enable insulation monitoring to take place, the LIM 27 is located subsea, and connected to the conductor pair downstream of the isolation transformer 32 via connection means 33.

The above-described embodiments are exemplary only, and other possibilities and alternatives within the scope of the invention will be apparent to those skilled in the art.

## Claims

1. A method of performing line insulation monitoring via a line insulation monitoring arrangement for an underwater hydrocarbon extraction facility connected to a surface location by a pair of conductor lines (L1, L2) at least partially located within an umbilical cable, comprising the steps of:
a) providing a first power switch (101) in a first conductor line (L1) of the pair and a second power switch (102) in a second conductor line (L2) of the pair,
b) providing a line insulation monitor (27) at a first end of the pair of conductor lines (L1, L2), electrically connected to the pair of conductor lines,
c) at a second end of the pair of conductor lines (L1, L2), electrically connecting the first and second conductor lines,
d) placing the first and second power switches into a monitoring configuration wherein the first power switch (101) is closed while the second power switch (102) is open, and
e) using the line insulation monitor (27) to monitor the insulation of the conductor lines (L1, L2).

2. The method according to claim 1, wherein step c) comprises connecting the first and second conductor lines to a winding of a transformer (28).

3. The method according to either of claims 1 and 2, wherein steps a) to e) are performed prior to closing both the first and the second switches (101,102).

4. The method according to any preceding claim, wherein the cable comprises an umbilical cable, the first end of the conductor pair is located at a surface location, and the second end is located at an underwater location.

5. The method according to any of claims 1 to 3, wherein the first and second ends of the conductor pair are located at an underwater location.

6. The method according to either of claims 4 and 5, for a subsea hydrocarbon extraction facility.

7. A line insulation monitoring arrangement for an underwater hydrocarbon extraction facility connected to a surface location by a pair of conductor lines (L1, L2) at least partially located within an umbilical cable, comprising a first power switch (101) located on a first conductor line (L1) of the pair and a second power switch (102) located on a second conductor line (L2) of the pair, each power switch (101,102) operable between open and closed configurations for respectively preventing or enabling electrical current flow therethrough, and control means for controlling the configuration of each of the first and second switches, wherein the first and second power switches (101,102) are independently operable and a line insulation monitor (27) electrically connected to the first and second conductor lines (L1, L2).

8. A hydrocarbon extraction facility comprising a surface location and an underwater location, the surface location and underwater location being electrically connected by a pair of conductor lines (L1, L2) at least partially located within an umbilical cable, comprising the line insulation monitoring arrangement of claim 7.

9. The hydrocarbon extraction facility according to claim 8, wherein the line insulation monitor (27) is provided at the surface location.

10. The hydrocarbon extraction facility according to claim 8, wherein the line insulation monitor (27) is provided at the underwater location.

## Patentansprüche

1. Verfahren zum Durchführen einer Leitungsisolationsüberwachung über eine Leitungsisolationsüberwachungsanordnung für eine Unterwasser-Kohlenwasserstoffextraktionsanlage, die mit einem Oberflächenstandort durch ein Leitungspaar (L1, L2) verbunden ist, das sich mindestens teilweise innerhalb eines Versorgungskabels befindet, umfassend die Schritte:
a) Bereitstellen eines ersten Leistungsschalters (101) in einer ersten Leitung (L1) des Paars und eines zweiten Leistungsschalters (102) in einer zweiten Leitung (L2) des Paars,
b) Bereitstellen eines Leitungsisolationswächters (27) an einem ersten Ende des Leitungspaars (L1, L2), der mit dem Leitungspaar elektrisch verbunden ist,
c) an einem zweiten Ende des Leitungspaars (L1, L2), elektrisches Verbinden der ersten und der zweiten Leitung,
d) Versetzen des ersten und des zweiten Leistungsschalters in eine Überwachungskonfiguration, wobei der erste Leistungsschalter (101) geschlossen ist, während der zweite Leistungsschalter (102) geöffnet ist, und
e) Verwenden des Leitungsisolationswächters (27), um die Isolation der Leitungen (L1, L2) zu überwachen.

2. Verfahren nach Anspruch 1, wobei Schritt c) das Verbinden der ersten und der zweiten Leitung mit einer Wicklung eines Transformators (28) umfasst.

3. Verfahren nach einem der Ansprüche 1 und 2, wobei die Schritte a) bis e) vor dem Schließen sowohl des ersten als auch des zweiten Schalters (101,102) durchgeführt werden.

4. Verfahren nach einem der vorstehenden Ansprüche, wobei das Kabel ein Versorgungskabel umfasst, sich das erste Ende des Leiterpaars an einem Oberflächenstandort befindet und sich das zweite Ende an einem Unterwasserstandort befindet.

5. Verfahren nach einem der Ansprüche 1 bis 3, wobei sich das erste und das zweite Ende des Leiterpaars an einem Unterwasserstandort befinden.

6. Verfahren nach einem der Ansprüche 4 und 5 für eine Unterwasser-Kohlenwasserstoffextraktionsanlage.

7. Leitungsisolationsüberwachungsanordnung für eine Unterwasser-Kohlenwasserstoffextraktionsanlage, die mit einem Oberflächenstandort durch ein Leitungspaar (L1, L2) verbunden ist, die sich mindestens teilweise innerhalb eines Versorgungskabels befinden, umfassend einen ersten Leistungsschalter (101), der sich auf einer ersten Leitung (L1) des Paars befindet, und einen zweiten Leistungsschalter (102), der sich auf einer zweiten Leitung (L2) des Paars befindet, wobei jeder Leistungsschalter (101,102) zwischen einer offenen und einer geschlossenen Konfiguration betreibbar ist, zum entsprechenden Verhindern oder Ermöglichen, dass Strom dort hindurch fließt, und Steuermittel, zum Steuern der Konfiguration jedes des ersten und des zweiten Schalters, wobei der erste und der zweite Leistungsschalter (101,102) unabhängig betreibbar sind, und einen Leitungsisolationswächter (27), der mit der ersten und der zweiten Leitung (L1, L2) elektrisch verbunden ist.

8. Kohlenwasserstoffextraktionsanlage, umfassend einen Oberflächenstandort und einen Unterwasserstandort, wobei der Oberflächenstandort und der Unterwasserstandort durch ein Leitungspaar (L1, L2), das sich mindestens teilweise innerhalb eines Versorgungskabels befindet, elektrisch verbunden sind, umfassend die Leitungsisolationsüberwachungsanordnung nach Anspruch 7.

9. Kohlenwasserstoffextraktionsanlage nach Anspruch 8, wobei der Leitungsisolationswächter (27) an dem Oberflächenstandort bereitgestellt ist.

10. Kohlenwasserstoffextraktionsanlage nach Anspruch 8, wobei der Leitungsisolationswächter (27) an dem Unterwasserstandort bereitgestellt ist.

## Revendications

1. Procédé pour effectuer une surveillance d'isolement de ligne par l'intermédiaire d'un agencement de surveillance d'isolement de ligne pour une installation sous-marine d'extraction d'hydrocarbures reliée à un emplacement en surface par une paire de lignes conductrices (L1, L2) situées au moins partiellement à l'intérieur d'un câble ombilical, comprenant les étapes consistant à :
a) fournir un premier commutateur de puissance (101) dans une première ligne conductrice (L1) de la paire et un second commutateur de puissance (102) dans une seconde ligne conductrice (L2) de la paire,
b) fournir un contrôleur d'isolement de ligne (27) à une première extrémité de la paire de lignes conductrices (L1, L2), connecté électriquement à la paire de lignes conductrices,
c) à une seconde extrémité de la paire de lignes conductrices (L1, L2), connecter électriquement les première et seconde lignes conductrices,
d) placer les premier et second commutateurs de puissance dans une configuration de surveillance dans laquelle le premier commutateur de puissance (101) est fermé tandis que le second commutateur de puissance (102) est ouvert, et
e) utiliser le contrôleur d'isolement de ligne (27) pour surveiller l'isolement des lignes conductrices (L1, L2).

2. Procédé selon la revendication 1, dans lequel l'étape c) comprend la connexion des première et seconde lignes conductrices à un enroulement d'un transformateur (28).

3. Procédé selon l'une des revendications 1 et 2, dans lequel les étapes a) à e) sont effectuées avant de fermer à la fois les premier et second commutateurs (101, 102).

4. Procédé selon l'une quelconque des revendications précédentes, dans lequel le câble comprend un câble ombilical, la première extrémité de la paire de conducteurs est située à un emplacement en surface, et la seconde extrémité est située à un emplacement sous-marin.

5. Procédé selon l'une quelconque des revendications 1 à 3, dans lequel les première et seconde extrémités de la paire de conducteurs sont situées à un emplacement sous-marin.

6. Procédé selon l'une des revendications 4 et 5, pour une installation sous-marine d'extraction d'hydrocarbures.

7. Agencement de surveillance d'isolation de ligne pour une installation d'extraction d'hydrocarbures sous-marine reliée à un emplacement en surface par une paire de lignes conductrices (L1, L2) au moins partiellement situées à l'intérieur d'un câble ombilical, comprenant un premier commutateur de puissance (101) situé sur une première ligne conductrice (L1) de la paire et un second commutateur de puissance (102) situé sur une seconde ligne conductrice (L2) de la paire, chaque commutateur de puissance (101, 102) pouvant être actionné entre des configurations ouvertes et fermées pour respectivement empêcher ou permettre la circulation de courant électrique à travers celui-ci, et des moyens de commande pour commander la configuration de chacun des premier et second commutateurs, dans lequel les premier et second commutateurs de puissance (101, 102) peuvent être actionnés indépendamment et un dispositif de surveillance d'isolation de ligne (27) connecté électriquement aux première et seconde lignes conductrices (L1, L2).

8. Installation d'extraction d'hydrocarbures comprenant un emplacement en surface et un emplacement sous-marin, l'emplacement en surface et l'emplacement sous-marin étant reliés électriquement par une paire de lignes conductrices (L1, L2) situées au moins partiellement à l'intérieur d'un câble ombilical, comprenant l'agencement de surveillance d'isolation de ligne selon la revendication 7.

9. Installation d'extraction d'hydrocarbures selon la revendication 8, dans laquelle le dispositif de surveillance d'isolement de ligne (27) est prévu à l'emplacement de surface.

10. Installation d'extraction d'hydrocarbures selon la revendication 8, dans laquelle le dispositif de surveillance d'isolement de ligne (27) est prévu à l'emplacement sous-marin.
